(19) **Europäisches Patentamt / European Patent Office / Office européen des brevets**

(11) **EP 3 147 909 B1**

(12) **FASCICULE DE BREVET EUROPEEN**

(45) Date de publication et mention de la délivrance du brevet:
**01.04.2020 Bulletin 2020/14**

(21) Numéro de dépôt: **16156143.6**

(22) Date de dépôt: **17.02.2016**

(51) Int Cl.:
**G11C 16/30** *(2006.01)*　　**G11C 16/32** *(2006.01)*
**G11C 16/10** *(2006.01)*　　**G11C 16/14** *(2006.01)*
G11C 29/02 *(2006.01)*　　G11C 29/12 *(2006.01)*
G11C 5/14 *(2006.01)*　　G11C 16/34 *(2006.01)*

(54) **PROCEDE DE CONTROLE D'UN CYCLE D'ECRITURE DE MEMOIRE DE TYPE EEPROM ET DISPOSITIF CORRESPONDANT**

VERFAHREN ZUR KONTROLLE EINES SCHREIBZYKLUS EINES SPEICHERS VOM TYP EEPROM, UND ENTSPRECHENDE VORRICHTUNG

METHOD FOR CONTROLLING AN EEPROM MEMORY WRITE CYCLE AND CORRESPONDING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.09.2015 FR 1559017**

(43) Date de publication de la demande:
**29.03.2017 Bulletin 2017/13**

(73) Titulaire: **STMicroelectronics (Rousset) SAS**
**13790 Rousset (FR)**

(72) Inventeurs:
• **TAILLIET, François**
**13710 FUVEAU (FR)**

• **BATTISTA, Marc**
**13013 MARSEILLE (FR)**

(74) Mandataire: **Casalonga**
**Casalonga & Partners**
**Bayerstraße 71/73**
**80335 München (DE)**

(56) Documents cités:
**EP-A1- 1 783 778　　US-A- 5 592 429**
**US-A- 5 729 494　　US-A- 6 044 015**
**US-A1- 2005 207 229　　US-A1- 2005 207 230**
**US-A1- 2007 237 008　　US-A1- 2011 194 364**
**US-A1- 2015 117 098**

**Description**

Des modes de mises en œuvre et de réalisations de l'invention concernent les mémoires, en particulier les mémoires non volatiles de type électriquement effaçables et programmables (EEPROM), et plus particulièrement le contrôle de leurs cycles d'écriture.

Une cellule-mémoire de type EEPROM comprend généralement un transistor ayant une grille flottante permettant la mémorisation de la donnée, une grille de commande, une région de source et une région de drain. Une telle cellule-mémoire utilise le principe de stockage non volatil de charges sur la grille flottante du transistor.

Classiquement, l'opération ou cycle d'écriture d'une donnée comporte une étape d'effacement suivie d'une étape de programmation. La programmation se fait par effet Fowler-Nordheim en utilisant une impulsion de tension ayant une valeur élevée, typiquement de l'ordre de 13 à 15 volts, injectant des électrons de la grille flottante vers le drain par effet tunnel.

L'effacement se fait également par effet Fowler-Nordheim, des électrons étant injectés par effet tunnel du drain vers la grille flottante, et s'effectue également en utilisant une impulsion d'effacement similaire à l'impulsion de programmation.

Les impulsions de programmation et d'effacement sont habituellement générées sous la forme d'une rampe suivie d'un plateau, par des moyens de génération d'impulsions comprenant classiquement un ou plusieurs étages de pompe de charge.

Cependant, il est possible que la sortance de la pompe de charge soit insuffisante pour atteindre les niveaux de tension nécessaires à l'effet Fowler-Nordheim, notamment en raison d'une tension d'alimentation trop faible et de fuites de courant. Cela se traduit par une erreur d'écriture et une altération des données.

Le courant consommé lors d'une opération d'écriture que devra fournir la pompe de charge peut s'exprimer selon une composante continue (DC) et une composante dynamique (AC).

La composante continue du courant consommé provient essentiellement des courants de fuite internes aux transistors recevant la haute tension lors des opérations d'écriture, et le cas échéant des caissons dans lesquels ces transistors sont positionnés.

La composante dynamique du courant consommé provient de la charge des différentes capacités parasites en provenance des composants et des interconnexions recevant la haute tension lors des opérations d'écriture.

En pratique, on peut exprimer le courant consommé par la pompe de charge selon l'équation (1) :

$$Ip = (Ic + Ctot.dV/dt).(Vpp/Vdd).1/Eff \qquad (1)$$

où Ip représente le courant consommé, Ic la composante continue de ce courant consommé, Ctot la capacité équivalente des nœuds du circuit recevant la haute tension, dV/dt représente la pente de la rampe, Vpp représente la haute-tension de sortie, Vdd représente la tension d'alimentation, et Eff représente l'efficacité de la pompe de charge.

Il existe des besoins de fonctionnement de mémoires de type EEPROM à des tensions d'alimentation faibles, par exemple de sensiblement 1.6 volts, notamment dans les systèmes « sans-fil » tels que par exemple des souris ou claviers d'ordinateur, ou des prothèses d'aide auditive.

En pratique les opérations à faible tension d'alimentation Vdd requièrent souvent, également un faible courant d'alimentation. Les consommations de courant élevées Ip sont donc préjudiciables aux systèmes dont la tension d'alimentation est faible.

Or, d'après l'équation (1), le courant consommé est d'autant plus important que le terme Vpp/Vdd est grand et donc que la tension d'alimentation Vdd est faible.

De plus, il existe des besoins d'écriture de mémoire de type EEPROM à fréquence élevée, ou temps d'écriture court, par exemple de sensiblement 1 ms par cycle d'écriture, notamment dans des systèmes de mémoire haute densité.

Or, d'après l'équation (1), le courant consommé est d'autant plus important que le terme dV/dt est grand et donc que le temps d'écriture prévu est court.

Enfin il est souvent requis qu'une même mémoire soit capable de fonctionner dans une large plage de tensions d'alimentation, typiquement de 1,6 volts à 5,5 volts.

Actuellement, des moyens de génération dimensionnés pour être fiable selon un temps d'écriture court à basse tension, par exemple 1,6V, sont par conséquent surdimensionnés lors d'un fonctionnement à haute tension, typiquement au dessus de 2,5 volts.

Ils requièrent par conséquent une surface importante et manquent d'efficacité à haute tension tout en générant d'importants pics de courant potentiellement nuisibles.

US2011/0194364A1 décrit une technique pour écrire un plus grand nombre de bits de données, comprenant une imbrication de fenêtres d'écriture de plusieurs bits écrits en parallèle, de sorte que le courant d'écriture maximal des bits respectifs soit décalé dans le temps par rapport au courant d'écriture maximal d'un autre bit.

US2005/0207230A1 décrit une technique d'effacement ou de programmation d'une mémoire non volatile prévoyant l'application d'une impulsion ayant un plateau sur la grille flottante du transistor de mémorisation.

US5592429A décrit un dispositif de mémoire à semiconducteur comprenant un circuit de décision de tension d'alimentation pour détecter si la tension d'alimentation est supérieure à un niveau prédéterminé pour produire un signal de sortie, un oscillateur qui produit un signal oscillant en tant que signal de sortie, un circuit de modification volontaire de valeur de compteur, et un circuit de compteur binaire, un intervalle de temps d'écriture ou d'effacement étant allongé par le signal de sortie, lorsque la tension d'alimentation devient inférieure au niveau prédéterminé.

Différents aspects, modes de réalisation et de mise en œuvre de l'invention sont définis par les revendications annexées. L'invention est définie par les revendications indépendantes 1 et 9. D'autres modes de réalisation préférés sont définis par les revendications dépendantes.

Selon un mode de mise en oeuvre et de réalisation il est proposé une mémoire de type EEPROM capable de fonctionner de manière efficace, notamment en ce qui concerne la pompe de charge, dans une large plage de tensions d'alimentation, par exemple 1,6 volts - 5,5 volts.

Une solution proposée comprend une adaptation contrôlée du temps d'écriture en fonction de la tension d'alimentation, ce qui permet aux moyens de génération d'impulsions, notamment la pompe de charge, de la mémoire de fonctionner de manière efficace aussi bien à faible tension qu'à haute tension, sans surdimensionnement de la pompe de charge ce qui se traduit par un gain de place.

Selon un aspect, il est proposé un procédé de contrôle d'un cycle d'écriture d'au moins une donnée dans au moins une cellule-mémoire du type mémoire morte électriquement programmable et effaçable disposée dans un circuit électronique alimenté par une tension d'alimentation, comprenant une augmentation contrôlée de la durée du cycle d'écriture en présence d'une baisse de tension d'alimentation.

L'augmentation contrôlée de la durée du cycle d'écriture permet de s'assurer que l'écriture des cellules-mémoire est correcte, même en cas de faible tension d'alimentation.

L'augmentation est contrôlée en ce sens qu'elle est effectuée volontairement et ajustée en fonction de l'amplitude de la baisse de la tension d'alimentation et donc en fonction de la valeur courante de la tension d'alimentation.

Alors qu'il est possible d'envisager une augmentation continue du temps d'écriture en fonction de la diminution de la tension d'alimentation, il est préférable pour des raisons pratiques que l'augmentation de la durée du cycle d'écriture comprenne une augmentation par au moins un palier correspondant respectivement à au moins une valeur palier de la tension d'alimentation inférieure à une valeur nominale.

Afin de détecter un besoin de modification du temps d'écriture, il est proposé au moins une comparaison de la valeur courante de ladite tension d'alimentation avec ladite au moins une valeur palier.

Ladite au moins une comparaison peut être réalisée avant le commencement du cycle d'écriture, ce qui permet de réaliser le cycle d'écriture dans une configuration optimisée en matière de durée d'écriture et de fiabilité.

Comme indiqué ci-avant, alors que l'opération d'écriture comprend généralement une étape d'effacement suivie d'une étape de programmation, il est possible, dans certains cas, qu'une seule étape d'effacement ou de programmation soit nécessaire pour écrire un mot dans la mémoire. Par exemple, si le mot à écrire ne contient que des « 0 », alors seule une étape d'effacement est nécessaire, et de même, lorsque le mot 0F (en notation hexadécimale) doit être remplacé par le mot 1F, l'étape d'effacement est inutile.

Ainsi, lorsque le cycle d'écriture comporte une génération d'au moins une impulsion d'effacement ou de programmation, l'augmentation de la durée du cycle d'écriture comprend une augmentation de la durée de ladite au moins une impulsion.

Lorsque le cycle d'écriture comprend une étape d'effacement comportant une génération d'une impulsion d'effacement suivie d'une étape de programmation comportant une génération d'une impulsion de programmation, l'augmentation de la durée du cycle d'écriture peut comprendre une augmentation de la durée de chaque impulsion.

Les moyens de génération d'impulsions comportent généralement un ou plusieurs étages de pompe de charge associés à une régulation de pompe de charge, et génèrent une impulsion haute tension, habituellement sous la forme d'une rampe suivie d'un plateau.

La régulation permet de contrôler la tension de sortie de la pompe de charge. Le niveau de régulation peut être par exemple le niveau de tension du plateau, typiquement de 15 volts.

La durée de l'impulsion (rampe + plateau) est commandée par un chronomètre (« timer »), analogique ou numérique.

Comme il est classique l'impulsion de programmation ou d'effacement, générée par le ou les étages de pompe de charge et la régulation associée, est appliquée à un circuit présentant une charge capacitive ainsi que des courants de fuites.

Lorsque la tension d'alimentation baisse, la sortance de la pompe de charge baisse fortement.

Et lorsque la sortance de la pompe de charge est faible, son courant peut être par exemple inférieur au courant nécessaire à la charge capacitive, auquel cas l'allure de la rampe se ralentit et prend une forme courbée. Le plateau est alors naturellement raccourci, la durée de l'impulsion étant fixée par le chronomètre.

Lorsque la sortance de la pompe de charge est faible, son courant peut aussi être inférieur auxdits courants de fuite et la tension du plateau nécessaire à l'opération d'écriture n'est alors pas atteinte.

Ces deux alternatives peuvent également se cumuler.

En d'autres termes, plus la tension d'alimentation est faible, plus les moyens de génération d'impulsion mettent de temps à fournir la valeur voulue du plateau, le plateau risque d'être de trop courte durée et/ou d'amplitude insuffisante, et l'écriture risque d'être incorrecte.

Ainsi il est proposé que le temps alloué à la rampe par le chronomètre soit suffisamment long en cas de basse tension, pour que la génération de la rampe n'empiète pas sur le temps alloué au plateau.

En d'autres termes, l'augmentation de la durée de ladite au moins une impulsion peut comprendre une augmentation de la durée de la rampe correspondante.

La durée de génération du plateau est alors suffisante pour une écriture fiable, et cela permet de conserver une sortance de la pompe de charge correcte en diminuant l'importance du terme dV/dt de l'équation (1) mentionnée ci-avant.

Néanmoins, il peut être avantageux d'augmenter la durée du plateau proportionnellement à l'augmentation de la durée de la rampe.

En effet, dans certaines approches, la durée de la rampe et la durée totale de l'impulsion sont définies par deux circuiteries analogiques indépendantes pouvant conduire à des variations de durées décorrélées. La solution proposée permet de s'affranchir des risques liés à la décorrélation desdites variations.

Ainsi, l'augmentation de la durée de ladite au moins une impulsion peut comprendre une augmentation de la durée du plateau.

Avantageusement en matière de consommation d'énergie notamment, l'opération d'écriture n'est pas altérée si la valeur de la tension de plateau diminue mais que sa durée augmente.

Ainsi, l'augmentation de la durée de ladite au moins une impulsion peut comprendre une diminution de la tension du plateau.

Cela permet d'adapter la consommation de courant du bloc alimenté par la pompe de charge, à une sortance réduite de la pompe de charge pour de faibles tensions d'alimentation. En effet la réduction de l'amplitude du plateau contribue à réduire la composante continue du courant consommé par la pompe de charge.

Selon un mode de mise en œuvre, la durée de ladite rampe est fixée à une durée nominale si la tension d'alimentation est supérieure à ladite valeur palier et est supérieure à ladite durée nominale si la tension d'alimentation est inférieure à la valeur palier.

Par exemple et à titre non-limitatif, la durée nominale de la rampe peut valoir sensiblement 0,25 ms et la durée supérieure à la durée nominale peut valoir sensiblement 1 ms.

Quoi qu'il en soit, les durées nominales des rampes et plateaux sont choisies de telle sorte que compte tenu de leurs variations, la durée d'une opération d'écriture reste inférieure à une durée maximale garantie.

Lorsque la valeur de la tension d'alimentation est comprise entre sensiblement 1,6V et sensiblement 5,5V et la valeur palier peut valoir sensiblement 2,5V.

Selon un autre aspect il est proposé un dispositif de mémoire destiné à être alimenté par une tension d'alimentation et comprenant au moins une cellule-mémoire du type mémoire morte électriquement programmable et effaçable, et des moyens de contrôle d'un cycle d'écriture configurés pour augmenter la durée du cycle d'écriture en présence d'une baisse de ladite tension d'alimentation.

Selon un mode de réalisation, les moyens de contrôle sont configurés pour augmenter la durée du cycle d'écriture par au moins un palier correspondant respectivement à au moins une valeur palier de la tension d'alimentation inférieure à une valeur nominale.

Selon un mode de réalisation, les moyens de contrôle comprennent au moins un moyen de comparaison de la valeur courante de ladite tension d'alimentation avec ladite au moins une valeur palier.

Selon un mode de réalisation, ledit au moins un moyen de comparaison est configuré pour réaliser au moins une comparaison avant le commencement du cycle d'écriture.

Selon un mode de réalisation, le dispositif comprend des moyens d'écriture comportant un moyen de génération d'au moins une impulsion d'effacement ou de programmation, et les moyens de contrôle sont configurés pour augmenter la durée du cycle d'écriture en augmentant la durée de ladite au moins une impulsion.

Selon un mode de réalisation, ledit moyen de génération est configuré pour générer une impulsion d'effacement suivie d'une impulsion de programmation, et les moyens de contrôle sont configurés pour augmenter la durée du cycle d'écriture en augmentant la durée de chaque impulsion.

Selon un mode de réalisation, ledit moyen de génération est configuré pour générer des impulsions comprenant une rampe de tension suivie d'un plateau, et les moyens de contrôle sont configurés pour augmenter la durée de ladite impulsion en augmentant la durée de la rampe correspondante.

Les moyens de contrôle peuvent être configurés pour augmenter la durée de ladite impulsion en augmentant la durée du plateau correspondant.

Les moyens de contrôle peuvent être configurés pour générer le plateau à une valeur diminuée si la durée de dudit plateau est augmentée.

Selon un mode de réalisation, les moyens de contrôle sont configurés pour générer la rampe pendant une durée fixée à une durée nominale si la tension d'alimentation est supérieure à ladite valeur palier et pendant une durée supérieure à ladite durée nominale si la tension d'alimentation est inférieure à ladite valeur palier.

La valeur de la tension d'alimentation peut être comprise entre sensiblement 1,6V et sensiblement 5,5V et la valeur palier peut valoir sensiblement 2,5V.

D'autres avantages et caractéristiques de l'invention apparaîtront à l'examen de la description détaillée de modes de mise en œuvre et de réalisation, nullement limitatifs, et des dessins annexés sur lesquels :

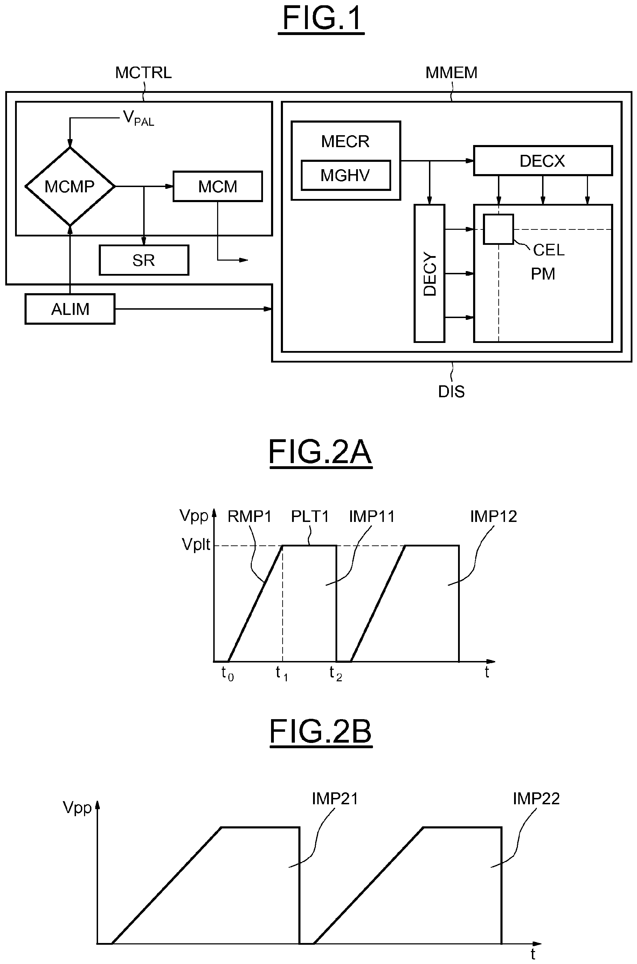

- les figures 1 à 5 illustrent schématiquement différents modes de mise en œuvre et de réalisation de l'invention.

La figure 1 représente schématiquement un dispositif DIS de mémoire de type EEPROM selon l'invention.

Ce dispositif DIS est alimenté par des moyens d'alimentation ALIM comprenant par exemple une pile ou une batterie, et comprend des moyens de mémorisation MMEM et des moyens de contrôle MCTRL.

Les moyens de mémorisation MMEM comportent un plan mémoire PM de cellules-mémoires CEL, ainsi que classiquement des décodeur lignes et colonnes DECX et DECY, et des moyens d'écriture MECR, de structures classiques et connues en soi.

Les moyens d'écriture MECR comportent notamment des moyens de génération d'impulsions haute tension MGHV comprenant notamment un générateur de rampe basé par exemple sur un intégrateur analogique, plusieurs étages de pompe de charge, un oscillateur, et la régulation associée.

La régulation permet de contrôler la tension de sortie de la pompe de charge. L'oscillateur est stoppé lorsque la sortie de la pompe de charge dépasse une référence haute. La tension de sortie de la pompe de charge commence alors à décroître en raison de la charge. Dès que la tension de sortie de la pompe de charge est inférieure à une référence basse, l'oscillateur redémarre. L'écart de tension entre les références basse et haute (hystérésis) assure la stabilité. Cette différence de tension est par exemple de l'ordre de 100 millivolts.

La rampe est générée grâce notamment à l'intégrateur analogique comprenant un condensateur, chargé par un courant constant, et suivi d'un suiveur de tension.

La rampe peut être également générée par la régulation de la pompe de charge elle-même. En effet, la tension de régulation peut elle-même être de la forme d'une rampe.

Comme indiqué précédemment, la durée de l'impulsion (rampe + plateau) est commandée par un chronomètre (« timer »), analogique ou numérique.

A titre indicatif, un chronomètre numérique peut comporter un oscillateur de fréquence fixe connecté à un compteur. Le compteur démarre lorsque la pompe de charge démarre et la fin du comptage marque la fin de l'impulsion.

Les caractéristiques du plateau (durée, tension) sont notamment déterminées par le chronomètre et une valeur de consigne.

Les moyens de contrôle MCTRL comportent des moyens de comparaison MCMP et des moyens de commande MCM comportant par exemple des moyens logiques de structures classiques notamment capables de commander différents éléments des moyens de contrôle MCTRL et de mémorisation MMEM, en particulier des éléments des moyens d'écriture MECR.

Les moyens de comparaison MCMP comportent par exemple un circuit comparateur, de structure classique, notamment capable de comparer la valeur de la tension d'alimentation à une valeur témoin, ou valeur palier, VPAL.

Les moyens de comparaison MCMP sont également capables de transmettre le résultat de la comparaison aux moyens de commande MCM, ou de le stocker par exemple dans un registre SR.

En fonction du résultat de la comparaison de la tension d'alimentation Vdd à la valeur palier VPAL, les moyens de commande MCM ajustent notamment les valeurs des courants et les capacités des condensateurs de l'intégrateur analogique et de la régulation de pompe de charge, la fréquence de l'oscillateur, ou encore le terme du comptage du compteur, afin que les moyens de génération d'impulsions génèrent l'impulsion selon une durée plus ou moins longue.

Plus précisément, si les moyens de comparaison MCMP indiquent une tension d'alimentation supérieure à la valeur palier VPAL, alors les moyens de commande MCM vont augmenter les valeurs des courants générateurs de la rampe, et/ou diminuer les capacités des condensateurs chargés par lesdits courants.

De tels ajustements se traduisent par une diminution de la durée de génération de la rampe.

A l'inverse, si les moyens de comparaison MCMP indiquent une tension d'alimentation inférieure à la valeur palier VPAL, alors les moyens de commande MCM vont diminuer la valeur des courants générateurs de la rampe, et augmenter les capacités des condensateurs chargés par lesdits courants.

De tels ajustements se traduisent par une augmentation de la durée de génération de la rampe.

Les variations des courants et des capacités sont réalisées de manière classique, respectivement en agissant sur des ratios de miroirs de courant et en intervertissant des condensateurs, par exemple.

D'autre part, les moyens de commande peuvent augmenter la durée du plateau, notamment en diminuant la fréquence de l'oscillateur et en augmentant le terme du comptage du compteur.

Les moyens de commande MCM peuvent également diminuer la tension du plateau, en diminuant par exemples les références haute et basse du régulateur de pompe de charge.

Selon un mode de mise en œuvre et de réalisation préférentiel, le plateau est généré pendant une durée proportionnelle à la durée de génération de la rampe correspondante.

D'autres moyens classiques présents dans le dispositif de mémoire DIS et non indispensables à la compréhension de l'invention n'ont volontairement pas été représentés sur la figure 1 à des fins de simplification.

Les différents profils des impulsions issues des moyens de génération d'impulsions MGHV seront étudiés plus en détail dans la suite.

En particuliers, les figures 2 à 5 représentent des profils d'impulsions générées par une même configuration des moyens de génération d'impulsions MGHV, mais commandés par les moyens de commande MCM pour différentes tensions d'alimentation Vdd, et différents mode de mise en œuvre ou de réalisation de l'invention.

Dans la suite, la pompe de charge est notamment dimensionnée pour générer des impulsions à une durée courte sous tension d'alimentation supérieure à la valeur palier de manière efficace et selon une consommation de l'opération d'écriture compatible avec la sortance de la pompe de charge.

Ce dimensionnement permet également de générer des impulsions à durée longue sous tension d'alimentation faible de manière efficace et selon une consommation de l'opération d'écriture compatible avec la sortance de la pompe de charge.

La figure 2A illustre des profils d'impulsions correspondant à un exemple de cycle d'écriture à durée courte sous tension d'alimentation Vdd supérieure à la valeur palier VPAL.

Dans cet exemple, l'opération d'écriture est réalisée par une impulsion d'effacement IMP11 suivie par une impulsion de programmation IMP12.

Chaque impulsion IMP11, IMP12 présente une rampe RMP1 suivie d'un plateau PLT1 typiquement à un niveau nominal Vplt de 15 volts.

A titre indicatif, la durée de l'opération d'écriture peut valoir par exemple 1 ms, et chaque impulsion IMP11, IMP12 peut être sensiblement de même durée, (t2-t0) de l'ordre de 0,5 ms avec des durées (t1-t0) de la rampe RMP1 et (t2-t1) du plateau PLT1 égales, de l'ordre de 0,25 ms.

Bien entendu, pour une même durée de l'opération ou cycle d'écriture, par exemple 1 ms, les impulsions IMP11, IMP12 pourraient présenter des rampes et/ou des plateaux de différentes durées et/ou de différentes valeurs.

Selon un aspect l'invention, une diminution de la tension d'alimentation Vdd en deçà de la valeur palier VPAL engendre une augmentation de la durée du cycle d'écriture.

La figure 2B illustre des profils d'impulsions correspondant à un cycle d'écriture dont la durée a été augmentée, dans une situation où la tension d'alimentation Vdd est inférieure à la valeur palier VPAL.

A titre indicatif, dans cette situation, la durée de l'opération d'écriture peut valoir par exemple 4 ms, et les impulsions d'effacement IMP21 et de programmation IMP22 peuvent être sensiblement de même durée.

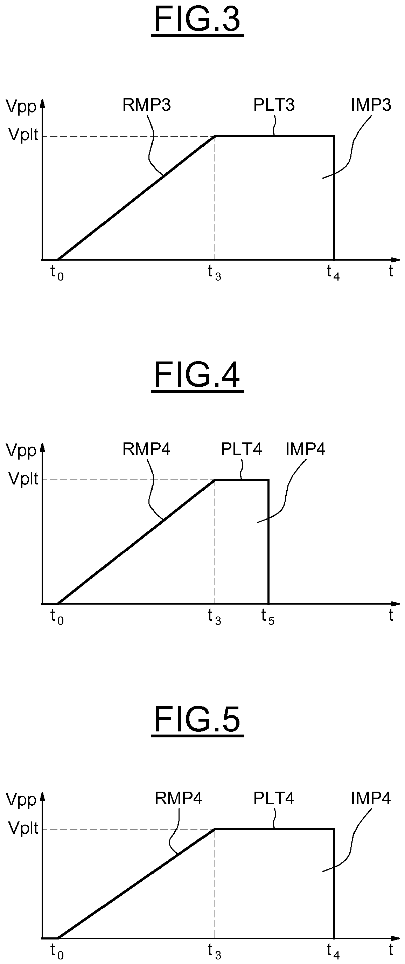

Les impulsions IMP21, IMP22 peuvent présenter, selon les modes de réalisation ou de mise en œuvre de l'invention, des rampes et/ou des plateaux de différentes durées et/ou de différentes valeurs comme cela va être détaillé sur les figures 3 à 5.

La figure 3 illustre une impulsion IMP3 pouvant être indifféremment une impulsion d'effacement ou de programmation, présentant une rampe RMP3 suivie d'un plateau PLT3 typiquement à un niveau nominal Vplt de 15 volts.

Cette impulsion IMP3 présente une durée de la rampe RMP3 et une durée du plateau PLT3 augmentée par rapport aux impulsions représentées en figure 2A.

A titre indicatif, la durée de l'impulsion IMP3 (t4-t0) peut valoir 2 ms, et les durées (t3-t0) de la rampe RMP3 et (t4-t3) du plateau PLT3 sont sensiblement égales, pouvant valoir environ 1 ms.

La figure 4 illustre une impulsion IMP4 pouvant être indifféremment une impulsion d'effacement ou de programmation, présentant une rampe RMP4 suivie d'un plateau PLT4 typiquement à un niveau nominal Vplt de 15 volts.

Cette impulsion IMP4 présente une durée de la rampe RMP4 augmentée et une durée du plateau PLT4 non augmentée par rapport aux impulsions représentées en figure 2A.

A titre indicatif, la durée de l'impulsion IMP4 (t5-t0) peut valoir environ 1,25 ms, et les durées (t3-t0) de la rampe RMP4 et (t5-t3) du plateau PLT4 peuvent valoir respectivement environ 1 ms et 0,25 ms.

La figure 5 illustre une impulsion IMP5 pouvant être indifféremment une impulsion d'effacement ou de programmation, présentant une rampe RMP5 suivie d'un plateau PLT5 à un niveau Vplt'.

Cette impulsion IMP5 présente une durée de la rampe RMP3 et du plateau PLT5 augmentées, et une valeur du plateau diminuée, par rapport aux impulsions représentées en figure 2A. La valeur Vplt' du plateau PLT5 est inférieure à la valeur Vplt des plateaux des modes de réalisations précédents, et peut valoir par exemple 14V.

A titre d'exemple, la durée de l'impulsion IMP5 (t4-t0) peut valoir environ 2 ms, et les durées (t3-t0) de la rampe RMP5 et (t4-t3) du plateau PLT5 sont sensiblement égales, pouvant valoir environ 1 ms.

L'invention n'est pas limitée aux modes de mise en œuvre et de réalisation qui viennent d'être décrits mais en embrasse toutes variantes.

Ainsi les impulsions d'effacement et de programmation peuvent respectivement ne pas être identiques en durée de rampe, en amplitude, en durée du plateau, ou en durée totale.

De même on peut envisager une augmentation de la durée du plateau sans augmenter la durée de la rampe, et une diminution de la tension du plateau, par exemple dans le but de réduire la consommation statique.

## Revendications

1. Procédé de contrôle d'un cycle d'écriture d'au moins une donnée dans au moins une cellule-mémoire du type mémoire morte électriquement programmable et effaçable disposée dans un circuit électronique alimenté par une tension d'alimentation (Vdd), comprenant une augmentation contrôlée de la durée du cycle d'écriture en présence d'une baisse de ladite tension d'alimentation, le procédé étant **caractérisé en ce que** le cycle d'écriture comporte une génération d'au moins une impulsion d'effacement ou de programmation par un ou plusieurs étages de pompe de charge associés à une régulation de pompe de charge, chaque impulsion comprenant une rampe de tension (RMP1) suivie d'un plateau (PLT1), la régulation permettant de contrôler la tension de sortie de la pompe de charge, le niveau de régulation étant le niveau de tension du plateau, la durée de ladite au moins une impulsion étant commandée par un chronomètre, et l'augmentation contrôlée de la durée du cycle d'écriture comprend une augmentation de la durée de ladite au moins une impulsion, l'augmentation de la durée de ladite au moins une impulsion comprenant une augmentation de la durée du plateau (PLT1) et une diminution de la valeur (Vpp) du plateau (PLT1).

2. Procédé selon la revendication 1, dans lequel l'augmentation de la durée du cycle d'écriture comprend une augmentation par au moins un palier correspondant respectivement à au moins une valeur palier (VPAL) de la tension d'alimentation, cette au moins une valeur palier (VPAL) étant inférieure à une valeur nominale.

3. Procédé selon la revendication 2, comprenant au moins une comparaison de la valeur courante de ladite tension d'alimentation (Vdd) avec ladite au moins une valeur palier (VPAL).

4. Procédé selon la revendication 3, dans lequel ladite au moins une comparaison est réalisée avant le commencement du cycle d'écriture.

5. Procédé selon l'une des revendications 1 à 4, dans lequel le cycle d'écriture comprend une étape d'effacement comportant une génération d'une impulsion d'effacement (IMP11) suivie d'une étape de programmation comportant une génération d'une impulsion de programmation (IMP12), et l'augmentation de la durée du cycle d'écriture comprend une augmentation de la durée de chaque impulsion (IMP11, IMP12).

6. Procédé selon l'une des revendications 1 à 5, dans lequel chaque impulsion comprend une rampe de tension (RMP1) suivie d'un plateau (PLT1) et l'augmentation de la durée de ladite au moins une impulsion comprend une augmentation de la durée de la rampe RMP1 correspondante.

7. Procédé selon la revendication 6 prise en combinaison avec la revendication 3, dans lequel la durée de ladite rampe (RMP1) est fixée à une durée nominale si la tension d'alimentation (Vdd) est supérieure à ladite valeur palier (VPAL) et est supérieure à ladite durée nominale si la tension d'alimentation (Vdd) est inférieure à la valeur palier (VPAL).

8. Procédé selon la revendication 7, dans lequel la valeur de la tension d'alimentation (Vdd) est comprise entre sensiblement 1,6V et sensiblement 5,5V et la valeur palier (VPAL) vaut sensiblement 2,5V.

9. Dispositif de mémoire (DIS), destiné à être alimenté par une tension d'alimentation (Vdd) et comprenant au moins une cellule-mémoire (CEL) du type mémoire morte électriquement programmable et effaçable, des moyens de contrôle d'un cycle d'écriture (MCTRL) configurés pour augmenter la durée du cycle d'écriture en présence d'une baisse de ladite tension d'alimentation (Vdd), le dispositif étant **caractérisé en ce qu'**il comprend des moyens d'écriture (MECR) comportant un moyen de génération (MGHV) comportant un ou plusieurs étages de pompe de charge associés à une régulation de pompe de charge, le moyen de génération (MGHV) étant configuré pour générer au moins une impulsion d'effacement ou de programmation comprenant une rampe (RMP1) de tension suivie d'un plateau (PLT1), la régulation permettant de contrôler la tension de sortie de la pompe de charge, le niveau de régulation étant le niveau de tension du plateau, la durée de ladite au moins une impulsion étant commandée par un chronomètre, les moyens de contrôle (MCTRL) étant configurés pour augmenter la durée du cycle d'écriture en augmentant la durée de ladite au moins une impulsion en augmentant la durée du plateau (PLT1) correspondant, et pour générer le plateau (PLT1) à une valeur (Vpp) diminuée si la durée de génération dudit plateau (PLT1) est augmentée.

10. Dispositif selon la revendication 9, dans lequel les moyens de contrôle (MCTRL) sont configurés pour augmenter la durée du cycle d'écriture par au moins un palier correspondant respectivement à au moins une valeur palier (VPAL) de la tension d'alimentation, cette au moins une valeur palier (VPAL) étant inférieure à une valeur nominale.

11. Dispositif selon la revendication 10, dans lequel les moyens de contrôle (MCTRL) comprennent au moins un moyen de comparaison (MCMP) configuré pour comparer la valeur courante de ladite tension d'alimentation (Vdd) avec ladite au moins une valeur palier(VPAL).

12. Dispositif selon la revendication 11, dans lequel ledit au moins un moyen de comparaison (MCMP) est configuré pour réaliser au moins une comparaison avant le commencement du cycle d'écriture.

13. Dispositif selon l'une des revendications 9 à 12, dans lequel ledit moyen de génération (MGHV) est configuré pour générer une impulsion d'effacement (IMP11) suivie d'une impulsion de programmation (IMP12), et les moyens de contrôle (MCTRL) sont configurés pour augmenter la durée du cycle d'écriture en augmentant la durée de chaque impulsion.

14. Dispositif selon l'une des revendications 9 à 13, dans lequel ledit moyen de génération (MGHV) est configuré pour générer des impulsions comprenant une rampe (RMP1) de tension suivie d'un plateau (PLT1), et les moyens de contrôle (MCTRL) sont configurés pour augmenter la durée de ladite impulsion en augmentant la durée de la rampe correspondante.

15. Dispositif selon la revendication 14 prise en combinaison avec la revendication 11, dans lequel les moyens de contrôle (MCTRL) sont configurés pour générer la rampe (RMP1) pendant une durée fixée à une durée nominale si la tension d'alimentation (Vdd) est supérieure à ladite valeur palier (VPAL) et pendant une durée supérieure à ladite durée nominale si la tension d'alimentation (Vdd) est inférieure à ladite valeur palier (VPAL).

16. Dispositif selon la revendication 15, dans lequel la valeur de la tension d'alimentation (Vdd) est comprise entre sensiblement 1,6V et sensiblement 5,5V et la valeur palier vaut sensiblement 2,5V.

**Patentansprüche**

1. Verfahren zur Kontrolle eines Schreibzyklus mindestens eines Datenwerts in mindestens einer elektrisch programmierbaren und löschbaren Speicherzelle der Art Festspeicher, die in einem elektronischen Schaltkreis angeordnet ist, der mit einer Versorgungspannung (Vdd) versorgt wird, das eine kontrollierte Verlängerung der Dauer des Schreibzyklus in Gegenwart eines Abfalls der Versorgungsspannung enthält, wobei das Verfahren **dadurch gekennzeichnet ist, dass** der Schreibzyklus eine Erzeugung mindestens eines Lösch- oder Programmierimpulses durch eine oder mehrere Ladungspumpenstufen aufweist, die einer Ladungspumpenregelung zugeordnet sind, wobei jeder Impuls eine Spannungsrampe (RMP1) gefolgt von einem Plateau (PLT1) enthält, wobei die Regelung es erlaubt, die Ausgangspannung der Ladungspumpe zu kontrollieren, wobei der Regelungspegel der Spannungspegel des Plateaus ist, wobei die Dauer des mindestens einen Impulses von einem Chronometer gesteuert wird, und die kontrollierte Verlängerung der Dauer des Schreibzyklus eine Verlängerung der Dauer des mindestens einen Impulses enthält, wobei die Verlängerung der Dauer des mindestens einen Impulses eine Verlängerung der Dauer des Plateaus (PLT1) und eine Verringerung des Werts (Vpp) des Plateaus (PLT1) enthält.

2. Verfahren nach Anspruch 1, wobei die Verlängerung der Dauer des Schreibzyklus eine Erhöhung um mindestens eine Stufe entsprechend mindestens einem Stufenwert (VPAL) der Versorgungsspannung enthält, wobei dieser mindestens eine Stufenwert (VPAL) niedriger als ein Nennwert ist.

3. Verfahren nach Anspruch 2, das mindestens einen Vergleich des aktuellen Werts der Versorgungsspannung (Vdd) mit dem mindestens einen Stufenwert (VPAL) enthält.

4. Verfahren nach Anspruch 3, wobei der mindestens eine Vergleich vor dem Beginn des Schreibzyklus durchgeführt wird.

5. Verfahren nach einem der Ansprüche 1 bis 4, wobei der Schreibzyklus einen Löschschritt enthält, der eine Erzeugung eines Löschimpulses (IMP11) gefolgt von einem Programmierschritt aufweist, der eine Erzeugung eines Programmierimpulses (IMP12) aufweist, und die Verlängerung der Dauer des Schreibzyklus eine Verlängerung der Dauer jedes Impulses (IMP11, IMP12) enthält.

6. Verfahren nach einem der Ansprüche 1 bis 5, wobei jeder Impuls eine Spannungsrampe (RMP1) gefolgt von einem Plateau (PLT1) enthält, und die Verlängerung der Dauer des mindestens einen Impulses eine Verlängerung der Dauer der entsprechenden Rampe RMP1 enthält.

7. Verfahren nach Anspruch 6 in Kombination mit Anspruch 3, wobei die Dauer der Rampe (RMP1) auf eine Nenndauer festgelegt wird, wenn die Versorgungsspannung (Vdd) höher als der Stufenwert (VPAL) ist, und länger ist als die Nenndauer, wenn die Versorgungsspannung (Vdd) niedriger ist als der Stufenwert (VPAL).

8. Verfahren nach Anspruch 7, wobei der Wert der Versorgungsspannung (Vdd) zwischen im Wesentlichen 1,6V und im Wesentlichen 5,5V liegt, und der Stufenwert (VPAL) im Wesentlichen 2,5V ist.

9. Speichervorrichtung (DIS), die dazu bestimmt ist, mit einer Versorgungsspannung (Vdd) versorgt zu werden und mindestens eine Speicherzelle (CEL) der Art elektrisch programmierbarer und löschbarer Festspeicher und Einrichtungen zur Kontrolle eines Schreibzyklus (MCTRL) enthält, die konfiguriert sind, die Dauer des Schreibzyklus in Gegenwart eines Abfalls der Versorgungsspannung (Vdd) zu verlängern, wobei die Vorrichtung **dadurch gekennzeichnet ist, dass** sie Schreibeinrichtungen (MECR) enthält, die eine Erzeugungseinrichtung (MGHV) aufweisen, die eine oder mehrere Ladungspumpenstufen aufweist, die einer Ladungspumpenregelung zugeordnet sind, wobei die Erzeugungseinrichtung (MGHV) konfiguriert ist, mindestens einen Lösch- oder Programmierimpuls zu erzeugen, der eine Spannungsrampe (RMP1) gefolgt von einem Plateau (PLT1) enthält,
wobei die Regelung es ermöglicht, die Ausgangsspannung der Ladungspumpe zu kontrollieren, wobei der Regelungspegel der Spannungspegel des Plateaus ist, wobei die Dauer des mindestens einen Impulses von einem Chronometer gesteuert wird,
wobei die Kontrolleinrichtungen (MCTRL) konfiguriert sind, die Dauer des Schreibzyklus zu verlängern, indem die Dauer des mindestens einen Impulses durch Verlängerung der Dauer des entsprechenden Plateaus (PLT1) verlängert wird, und um das Plateau (PLT1) auf einem verringerten Wert (Vpp) zu erzeugen, wenn die Erzeugungsdauer des Plateaus (PLT1) verlängert ist.

10. Vorrichtung nach Anspruch 9, wobei die Kontrolleinrichtungen (MCTRL) konfiguriert sind, die Dauer des Schreibzyklus um mindestens eine Stufe zu verlängern, die mindestens einem Stufenwert (VPAL) der Versorgungsspannung entspricht, wobei dieser mindestens eine Stufenwert (VPAL) niedriger als ein Nennwert ist.

11. Vorrichtung nach Anspruch 10, wobei die Kontrolleinrichtungen (MCTRL) mindestens eine Vergleichseinrichtung (MCMP) enthalten, die konfiguriert ist, den aktuellen Wert der Versorgungsspannung (Vdd) mit dem mindestens einen Stufenwert(VPAL) zu vergleichen.

12. Vorrichtung nach Anspruch 11, wobei die mindestens eine Vergleichseinrichtung (MCMP) konfiguriert ist, mindestens einen Vergleich vor dem Beginn des Schreibzyklus durchzuführen.

13. Vorrichtung nach einem der Ansprüche 9 bis 12, wobei die Erzeugungseinrichtung (MGHV) konfiguriert ist, einen Löschimpuls (IMP11) gefolgt von einem Programmierimpuls (IMP12) zu erzeugen, und die Kontrolleinrichtungen (MCTRL) konfiguriert sind, die Dauer des Schreibzyklus zu verlängern, indem die Dauer jedes Impulses verlängert wird.

14. Vorrichtung nach einem der Ansprüche 9 bis 13, wobei die Erzeugungseinrichtung (MGHV) konfiguriert ist, Impulse zu erzeugen, die eine Spannungsrampe (RMP1) gefolgt von einem Plateau (PLT1) enthalten, und die Kontrolleinrichtungen (MCTRL) konfiguriert sind, die Dauer des Impulses zu verlängern, indem die Dauer der entsprechenden Rampe verlängert wird.

15. Vorrichtung nach Anspruch 14 in Kombination mit Anspruch 11, wobei die Kontrolleinrichtungen (MCTRL) konfiguriert sind, die Rampe (RMP1) während einer auf eine Nenndauer festgelegten Dauer, wenn die Versorgungsspannung (Vdd) höher ist als der Stufenwert (VPAL), und während einer Dauer länger als die Nenndauer zu erzeugen, wenn die Versorgungsspannung (Vdd) niedriger ist als der Stufenwert (VPAL).

16. Vorrichtung nach Anspruch 15, wobei der Wert der Versorgungsspannung (Vdd) zwischen im Wesentlichen 1,6V und im Wesentlichen 5,5V liegt, und der Stufenwert im Wesentlichen 2,5V beträgt.

**Claims**

1. Method of controlling a cycle for writing at least one data item to at least one memory cell of the electrically erasable and programmable read-only memory type disposed in an electronic circuit supplied by a supply voltage (Vdd), comprising a controlled increase in the duration of the write cycle in the presence of a drop in the said supply voltage, the method being **characterized in that** the write cycle comprises a generation of at least one erasure or programming pulse by one or more charge pump stages associated with a charge pump regulator, each pulse comprising a voltage ramp (RMP1) followed by a plateau (PLT1), the regulation permitting to control the output voltage of the charge pump, the regulation level being the voltage level of the plateau, the duration of the said at least one pulse being controlled by a chronometer, and the controlled increase in the duration of the write cycle comprises an increase in the duration of the said at least one pulse, the increase in the duration of the said at least one pulse comprising an increase in the duration of the plateau (PLT1) and a decrease in the value (Vpp) of the plateau (PLT1) .

2. Method according to Claim 1, in which the increase in the duration of the write cycle comprises an increase by at least one notch corresponding respectively to at least one notch value (VPAL) of the supply voltage, this at least one notch value (VPAL) being lower than a nominal value.

3. Method according to Claim 2, comprising at least one comparison of the current value of the said supply voltage (Vdd) with the said at least one notch value (VPAL).

4. Method according to Claim 3, in which the said at least one comparison is carried out before the beginning of the write cycle.

5. Method according to one of Claims 1 to 4, in which the write cycle comprises an erasure step comprising a generation of an erasure pulse (IMP11) followed by a programming step comprising a generation of a programming pulse (IMP12), and the increase in the duration of the write cycle comprises an increase in the duration of each pulse (IMP11, IMP12).

6. Method according to one of Claims 1 to 5, in which each pulse comprises a voltage ramp (RMP1) followed by a plateau (PLT1) and the increase in the duration of the said at least one pulse comprises an increase in the duration of the corresponding ramp RMP1.

7. Method according to Claim 6 taken in combination with Claim 3, in which the duration of the said ramp (RMP1) is fixed at a nominal duration if the supply voltage (Vdd) is greater than the said notch value (VPAL) and is greater than the said nominal duration if the supply voltage (Vdd) is lower than the notch value (VPAL).

8. Method according to Claim 7, in which the value of the supply voltage (Vdd) lies between substantially 1.6V and substantially 5.5V and the notch value (VPAL) is substantially 2.5V.

9. Memory device (DIS), intended to be supplied by a supply voltage (Vdd) and comprising at least one memory cell (CEL) of the electrically erasable and programmable read-only memory type, and write cycle control means (MCTRL) configured to increase the duration of the write cycle in the presence of a drop in the said supply voltage (Vdd), the device being **characterized in that** it comprises writing means (MECR) comprising a generating means (MGHV) comprising one or more charge pump stages associated with a charge pump regulation, the generating means (MGHV) being configured to generate at least one erasure or programming pulse comprising a voltage ramp (RMP1) followed by a plateau (PLT1),
the regulation permitting to control the output voltage of the charge pump, the regulation level being the voltage level of the plateau, the duration of the said at least one pulse being controlled by a chronometer, the control means (MCTRL) being configured to increase the duration of the write cycle by increasing the duration of the said at least one pulse by increasing the duration of the corresponding plateau (PLT1), and to generate the plateau (PLT1) at a decreased value (Vpp) if the duration of generation of the said plateau (PLT1) is increased.

10. Device according to Claim 9, in which the control means (MCTRL) are configured to increase the duration of the write cycle by at least one notch corresponding respectively to at least one notch value (VPAL) of the supply voltage, this at least one notch value (VPAL) being lower than a nominal value.

11. Device according to Claim 10, in which the control means (MCTRL) comprise at least one comparison means (MCMP) configured to compare the current value of the said supply voltage (Vdd) with the said at least one notch value (VPAL).

12. Device according to Claim 11, in which the said at least one comparison means (MCMP) is configured to carry out at least one comparison before the beginning of the write cycle.

13. Device according to one of Claims 9 to 12, in which the said generating means (MGHV) is configured to generate an erasure pulse (IMP11) followed by a programming pulse (IMP12), and the control means (MCTRL) are configured to increase the duration of the write cycle by increasing the duration of each pulse.

14. Device according to one of Claims 9 to 13, in which the said generating means (MGHV) is configured to generate pulses comprising a voltage ramp (RMP1) followed by a plateau (PLT1), and the control means (MCTRL) are configured to increase the duration of the said pulse by increasing the duration of the corresponding ramp.

15. Device according to Claim 14, taken in combination with Claim 11, in which the control means (MCTRL) are configured to generate the ramp (RMP1) for a duration fixed at a nominal duration if the supply voltage (Vdd) is greater than the said notch value (VPAL) and for a duration greater than the said nominal duration if the supply voltage (Vdd) is lower than the said notch value (VPAL).

16. Device according to Claim 15, in which the value of the supply voltage (Vdd) lies between substantially 1.6V and substantially 5.5V and the notch value is substantially 2.5V.

# FIG.1

# FIG.2A

# FIG.2B

## FIG.3

## FIG.4

## FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20110194364 A1
- US 20050207230 A1
- US 5592429 A